# EUROPEAN PATENT APPLICATION

(11) **EP 4 815 655 A1**
(43) Date of publication of application: **30.09.2026**
(21) Application number: 26723253.6
(22) Date of filing: 30.01.2026
(51) Int. Cl.: H05K 7/20

(54) **ELECTRONIC DEVICE COMPRISING VAPOR CHAMBER**

(30) Priority: 07.02.2025 KR 20250016197; 24.03.2025 KR 20250037211
(71) Applicant: Samsung Electronics Co., Ltd, Suwon-si, Gyeonggi-do 16677 (KR)
(72) Inventor: KIM, Sungjun, Suwon-si, Gyeonggi-do 16677 (KR)
(74) Representative: Appleyard Lees IP LLP
(86) International application number: PCT/KR2026/001787
(87) International publication number: WO 2026/168880

(57) **Abstract**

An electronic device according to an embodiment may include a display, a support member disposed on a rear surface of the display, a processor disposed in one region of the support member and a vapor chamber for absorbing heat produced by the processor. According to an embodiment, the vapor chamber may be integrally formed with a cover which covers the processor.

## Description

### [Technical Field]

The disclosure relates to an electronic device provided with a vapor chamber.

### [Background Art]

A vapor chamber in a smartphone provides cooling technology for efficiently managing heat in the smartphone. Vapor chambers are mostly used in high-performance smartphones or gaming smartphones, and serve to spread heat that is generated therein.

A thermal interface material, "TIM", can be provided together with the vapor chamber in the smartphone. The TIM is a type of a heat transfer material. The TIM is used to enhance heat transfer efficiency between a heat producing component, e.g., a central processing unit, "CPU",, or a graphics processing unit, "GPU", and a heat sink or a cooling arrangement.

Since frame components for securing the vapor chamber, TIM and a printed circuit board that carries the heat producing components each have their own thickness, the thickness of such components may become a factor when trying to construct a smartphone with increased slimness.

The foregoing information may be provided as related art for the purpose of aiding understanding of the disclosure. No claim or determination is made as to whether any of the foregoing may be applied as the prior art in connection with the disclosure.

### [Disclosure of Invention]

### [Solution to Problem]

An electronic device according to an embodiment may include a display, a support member disposed on a rear surface of the display, a processor disposed in one region of the support member and a vapor chamber for absorbing heat produced by the processor. According to an embodiment, the vapor chamber may be integrally formed with a cover which covers the processor.

An electronic device according to an embodiment may include a support member, a display coupled to one surface of the support member, a substrate coupled to the other surface of the support member, a battery disposed on one surface of the substrate and a vapor chamber for absorbing heat produced by the battery. According to an embodiment, the vapor chamber may be integrally formed with a cover which covers the battery.

According to the present invention there is provided an apparatus as set forth in the appended independent claims. Other features of the invention will be apparent from the dependent claims, and the description which follows.

### [Brief Description of Drawings]

FIG. 1 is a block diagram of an electronic device in a network environment.
FIG. 2A is a front perspective view of an electronic device.
FIG. 2B is a rear perspective view of the electronic device of FIG. 2A.
FIG. 3 is an exploded perspective view of an electronic device according to an example embodiment.
FIG. 4 is a view for illustrating a position and a heat transfer path of a conventional vapor chamber.
FIG. 5 is an exploded perspective view of an electronic device including a vapor chamber according to an example embodiment.
FIG. 6 is a rear view of an electronic device according to an example embodiment.
FIG. 7 is a cross-sectional perspective view of an electronic device when viewed from the back according to an example embodiment.
FIG. 8 is a configuration view of a vapor chamber according to an example embodiment.
FIG. 9 is a configuration view of a cover of a vapor chamber according to an example embodiment.
FIG. 10 illustrates a heat transfer path of an electronic device according to an example embodiment.
FIG. 11 illustrates a heat dissipation path of a vapor chamber according to an example embodiment.

### [Mode for the Invention]

Hereinafter, preferred embodiments of the present invention will be described in detail with reference to the accompanying drawings. Advantages and features of the present invention, and methods for achieving them will become clear upon reference to the embodiments described in detail below with reference to the accompanying drawings. However, the present invention is not limited to the embodiments disclosed herein, but may be embodied in various different forms, these embodiments are provided merely to make the disclosure of the present invention complete and to fully inform those skilled in the art to which the present invention pertains of the scope of the invention, and the present invention is defined solely by the scope of the claims. Throughout the specification, the same reference numerals indicate the same components.

Unless otherwise defined, all terms used in this specification (including technical and scientific terms) may be used in the meanings commonly understood by those skilled in the art to which the present invention pertains. Also, terms defined in commonly used dictionaries are not interpreted ideally or excessively unless explicitly defined otherwise. The terms used in this specification are for illustrating embodiments and are not intended to limit the present invention. In this specification, the singular form includes the plural unless the context specifically requires otherwise.

"comprises" and/or "comprising" as used in this specification do not exclude presence or addition of one or more other components, steps, operations and/or elements thereof.

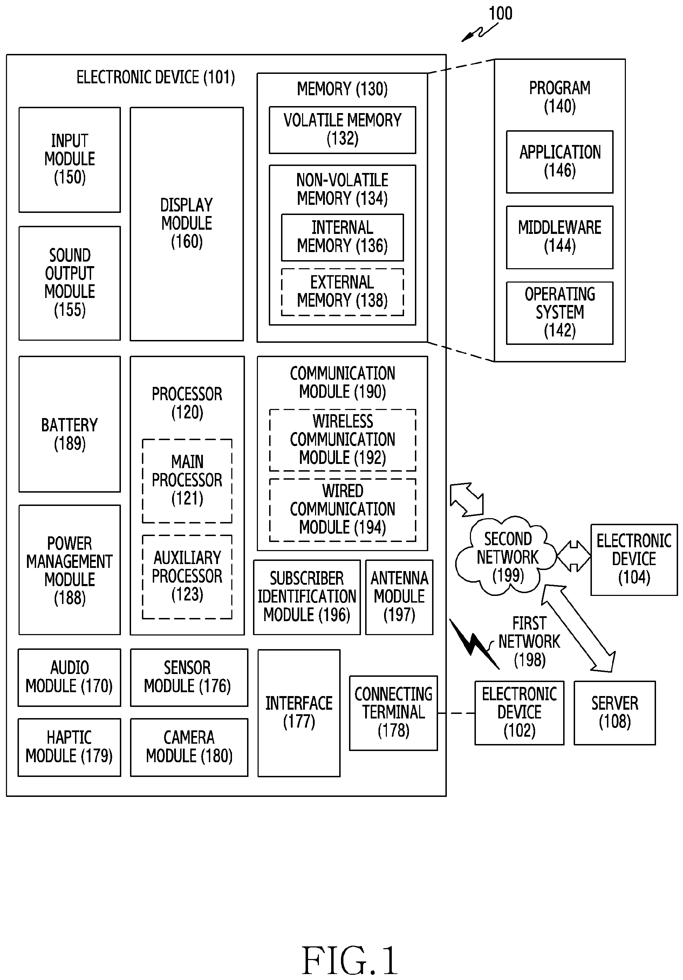

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

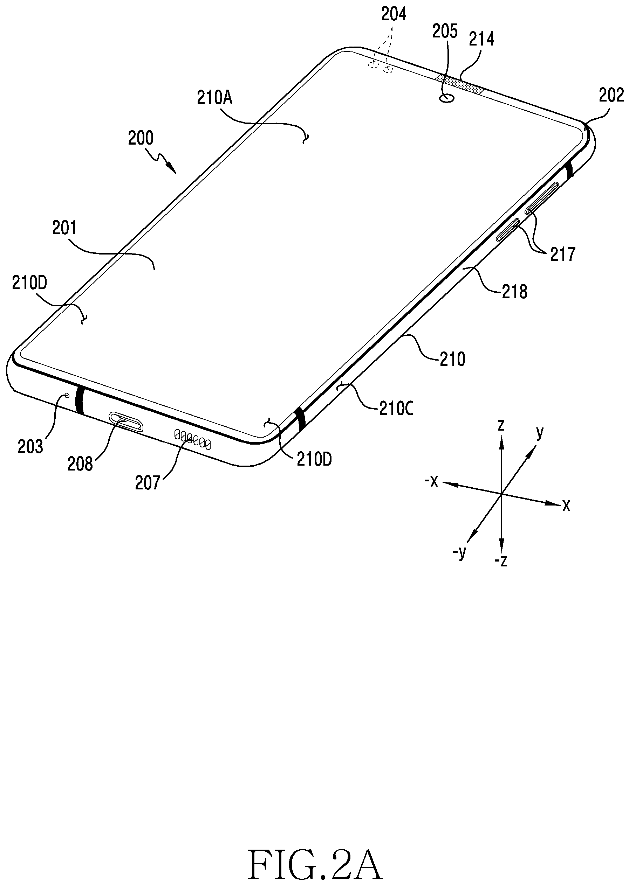

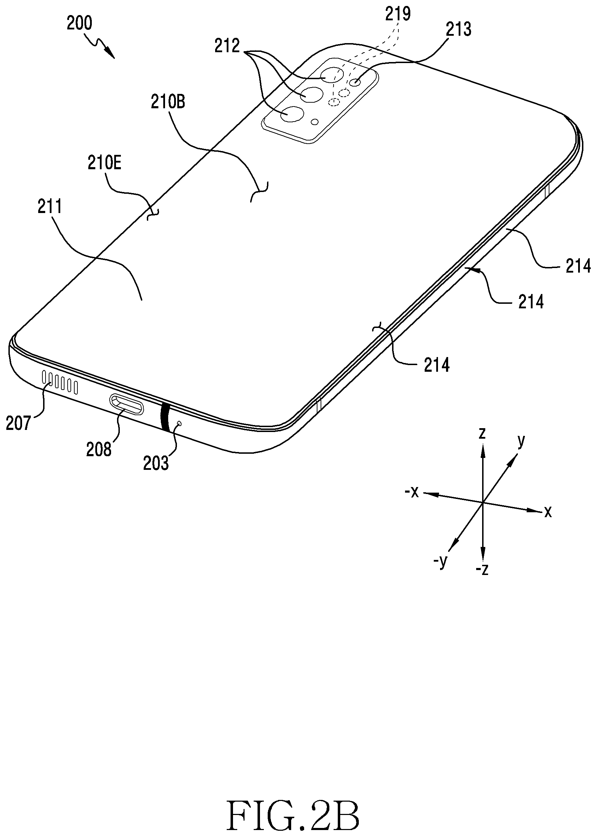

FIG. 2A is a front perspective view of an electronic device. FIG. 2B is a rear perspective view of the electronic device of FIG. 2A.

An electronic device 200 described below may include at least one of the components of the electronic device 101 mentioned earlier in FIG. 1. As shown in FIG. 2A and 2B the electronic device 200 comprises a smartphone.

Referring to FIG. 2A and FIG. 2B, the electronic device 200 includes a housing 210 which includes a first surface (or a front surface) 210A, a second surface (or a rear surface) 210B, and a side surface 210C for surrounding a space between the first surface 210A and the second surface 210B. In other embodiments (not shown), the term housing may be used to indicate a structure that forms parts of the first surface 210A, the second surface 210B and the side surfaces 210C of FIG. 2A. The first surface 210A is formed at least in part by a front plate 202 (e.g., a glass plate or a polymer plate including various coating layers) which is substantially transparent. The second surface 210B is formed by a rear plate 211 which is substantially opaque. The rear plate 211 is formed, for example, by coated or tinted glass, ceramic, polymer, metal (e.g., aluminum, stainless steel (STS), or magnesium), or a combination of at least two of these materials. The side surface 210C is formed by a side bezel structure 218 (or a "side member") which couples with the front plate 202 and the rear plate 211 and includes a metal and/or a polymer. The rear plate 211 and the side bezel structure 218 may be formed integrally and include the same material (e.g., a metallic material such as aluminum).

In the illustrated embodiment, the front plate 202 includes a first region 210D which is curved from the first surface 210A toward the rear plate to seamlessly extend, at both ends of a long edge of the front plate. In the illustrated embodiment (see FIG. 2B), the rear plate 211 includes a second region 210E at both ends of its long edge, which is curved from the second surface 210B toward the front plate to extend seamlessly. The front plate 202 or the rear plate 211 may include only one of the first region 210D or the second region 210E. The front plate 202 may not include the first region and the second region, but may only include a flat plane disposed in parallel to the second surface 210B. In the embodiments, when viewed from the side of the electronic device, the side bezel structure 218 may have a first thickness (or width) on the side surface not including the first region 210D or the second region 210E as above, and a second thickness thinner than the first thickness on the side surface including the first region 210D or the second region 210E.

The electronic device 200 may include at least one or more of a display 201, an input device 203, audio output devices 207 and 214, sensor modules 204 and 219, camera modules 205 and 212, a key input device 217, an indicator (not shown), and a connector 208. The electronic device 200 may omit at least one (e.g., the key input device 217, or the indicator) of the components or include an additional component.

The display 201 may be visually exposed through, for example, a substantial portion of the front plate 202. At least a part of the display 201 may be exposed through the first surface 210A, and the front plate 202 forming the first region 210D of the side surface 210C. The display 201 may be coupled with or disposed adjacent to a touch sensing circuit, a pressure sensor for measuring the intensity (pressure) of a touch, and/or a digitizer for detecting a magnetic field-based stylus pen. At least a part of the sensor modules 204 and 219 and/or at least a part of the key input device 217 may be disposed in the first region 210D and/or the second region 210E.

The input device 203 may include the microphone 203. The input device 203 may include a plurality of microphones 203 disposed to detect the direction of sound. The audio output devices 207 and 214 may include speakers 207 and 214. The speakers 207 and 214 may include the external speaker 207 and the call receiver 214. The microphone 203, the speakers 207 and 214, and the connector 208 may be disposed at least in part within an internal space of the electronic device 200, and may be exposed to an external environment through at least one hole formed in the housing 210. The hole formed in the housing 210 may be commonly used for the microphone 203 and the speakers 207 and 214. The audio output devices 207 and 214 may include a speaker (e.g., a piezo speaker) operating, without the hole formed in the housing 210.

The sensor modules 204 and 219 may generate an electrical signal or a data value corresponding to an internal operating state of the electronic device 200, or the external environmental state. The sensor modules 204 and 219 may include, for example, the first sensor module 204 (e.g., a proximity sensor) and/or a second sensor module (not shown) (e.g., a fingerprint sensor) disposed on the first surface 210A of the housing 210, and/or a third sensor module 219 (e.g., a heart rate monitor "HRM" sensor) disposed on the second surface 210B of the housing 210. The fingerprint sensor may be disposed below the first surface 210A (e.g., a home key button) of the housing 210, a partial region of the second surface 210B, and/or the display 201. The electronic device 200 may further include a sensor module not shown, for example, at least one of a gesture sensor, a gyro sensor, a barometric sensor, a magnetic sensor, an accelerometer, a grip sensor, a color sensor, an infrared "IR" sensor, a biometric sensor, a temperature sensor, a humidity sensor, a proximity sensor or an illuminance sensor.

The camera modules 205 and 212 may include the first camera module 205 disposed on the first surface 210A of the electronic device 200, the second camera module 212 disposed on the second surface 210B, and/or a flash 213. The camera modules 205 and 212 may include one or more lenses, an image sensor, and/or an image signal processor. The flash 213 may include, for example, a light emitting diode or a xenon lamp. Two or more lenses (a wide-angle lens, an ultra-wide-angle lens, or a telephoto lens) and image sensors may be arranged on one surface of the electronic device 200.

The key input device 217 may be disposed on the side surface 210C of the housing 210. The electronic device 200 may not include some or all of the aforementioned key input devices 217, and the key input device 217 not included may be implemented in a different form such as a soft key on the display 201. The key input device 217 may be implemented using a pressure sensor included in the display 201.

The indicator may be disposed, for example, on the first surface 210A of the housing 210. The indicator may, for example, provide status information of the electronic device 200 in the form of light (e.g., a light emitting element). The light emitting element may provide a light source associated with, for example, an operation of the camera module 205. The indicator may include, for example, a light emitting diode "LED", an IR LED and/or a xenon lamp.

The connector hole 208 may include the first connector hole 208 for accommodating a connector (e.g., a universal serial bus "USB" connector) for transmitting and receiving power and/or data to and from an external electronic device, and/or a second connector hole (or an earphone jack) (not shown) for accommodating a connector for transmitting and receiving an audio signal to and from an external electronic device.

Some camera module(s) 205 of the camera modules 205 and 201, some sensor module(s) 204 of the sensor modules 204 and 219, or the indicator may be disposed to be visually exposed through the display 201. For example, the camera module 205, the sensor module 204, or the indicator may be disposed within the internal space of the electronic device 200, to contact the external environment through an opening or a transmissive region perforated up to the front plate 202 in the display 201.The region where the display 201 and the camera module 205 face each other may be formed as a transmissive region having a specific transmittance rate as a part of a content displaying region. The transmissive region may be formed to have the transmittance ranging from about 5% to about 20%. This transmissive region may include a region overlapping with an effective region (e.g., a field of view region) of the camera module 205 through which light passes to form an image on the image sensor. For example, the transmissive region of the display 201 may include a region with a lower pixel density than the surrounding region. For example, the transmissive region may replace the opening. For example, the camera module 205 may include an under display camera "UDC". In an embodiment, some sensor module(s) 204 may be disposed within the internal space of the electronic device to perform their function without being visually exposed through the front plate 202. For example, in this case, the region of the display 201 facing the sensor module may not need the perforated opening.

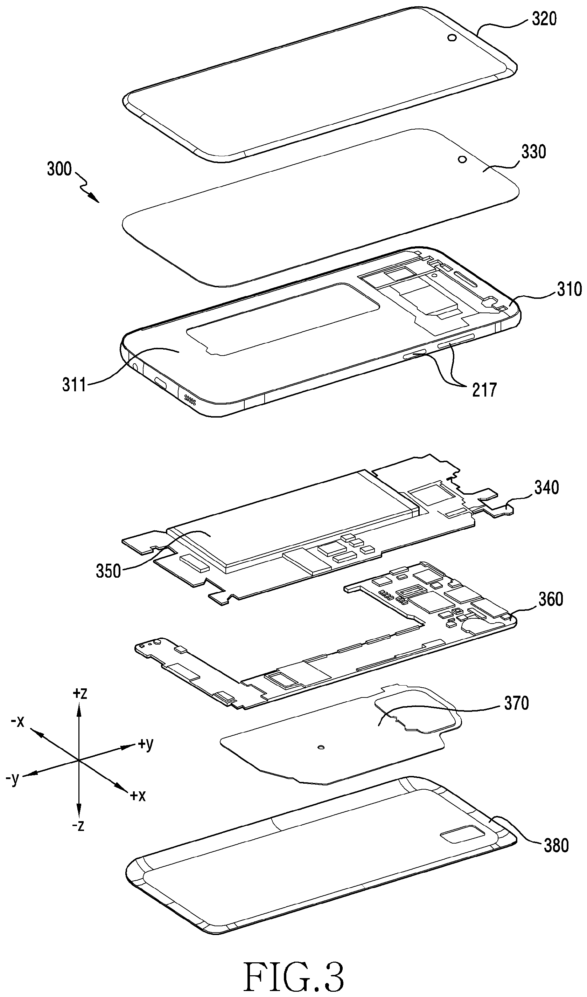

The electronic device 200 has a bar-type or plate-type appearance, but the present invention is not limited to implementation in electronic devices with this category of form-factor. For example, the electronic device 200 depicted may be part of a foldable electronic device, a slidable electronic device, a stretchable electronic device and/or a rollable electronic device. The terms "foldable electronic device," "slidable electronic device," "stretchable electronic device," and/or "rollable electronic device" may indicate an electronic device where bending deformation of the display (e.g., the display 330 of FIG. 3) is possible, and accordingly at least a part thereof may be folded, wound or rolled, or a region thereof may be extended at least in part and/or received in the housing (e.g., the housing 210 of FIG. 2A and FIG. 2B). The foldable electronic device, the slidable electronic device, the stretchable electronic device and/or the rollable electronic device may expand and use a screen display region according to a user's need by unfolding the display or exposing a wider area of the display to the outside.

FIG. 3 is an exploded perspective view of an electronic device of FIG. 2A, according to an embodiment of the disclosure.

An electronic device 300 of FIG. 3 may include features similar to, or as described for the electronic device 200 of FIG. 2A and FIG. 2B, or may include another embodiment of such an electronic device.

Referring to FIG. 3, the electronic device 300 (e.g., the electronic device 200 of FIG. 2A or FIG. 2B) may include a side member 310 (e.g., a side bezel structure), a first support member 311 (e.g., a bracket or a support structure), a front plate 320 (e.g., a front cover), a display 330 (e.g., the display 201 of FIG. 2A), a substrate 340 (e.g., a printed circuit board "PCB", a flexible PCB "FPCB", or a rigid-flexible PCB "RFPCB"), a battery 350, a second support member 360 (e.g., a rear case), an antenna 370, and a rear plate 380 (e.g., a rear cover). The electronic device 300 may omit at least one (e.g., the first support member 311, or the second support member 360) of the components and/or may additionally include other components. At least one of the components of the electronic device 300 may be identical or similar to at least one of the components of the electronic device 200 of FIG. 2A or FIG. 2B, and redundant descriptions thereof shall be omitted.

The first support member 311 may be disposed within the electronic device 300 and connected to the side member 310, or may be integrally formed with the side member 310. The first support member 311 may be formed, for example, from a metallic material and/or a non-metallic material (e.g., a polymer). The first support member 311 may be coupled to the display 330 on one surface and coupled to the substrate 340 on the other surface. A processor, a memory, and/or an interface may be mounted on the substrate 340. The processor may include, for example, one or more of a central processing unit, an application processor, a graphics processing unit, an image signal processor, a sensor hub processor, or a communication processor.

The memory may include, for example, a volatile memory or a non-volatile memory.

The interface may include, for example, a high definition multimedia interface "HDMI", a USB interface, a secure digital "SD" card interface, and/or an audio interface. The interface may, for example, electrically or physically connect the electronic device 300 to an external electronic device, and may include a USB connector, an SD card/multimedia card "MMC" connector, or an audio connector.

The battery 350 is a device for supplying power to at least one component of the electronic device 300, and may include, for example, a non-rechargeable primary battery, a rechargeable secondary battery, or a fuel cell. At least a part of the battery 350 may be disposed on substantially the same plane as the substrate 340. The battery 350 may be integrally disposed within the electronic device 300. The battery 350 may be disposed detachably from the electronic device 300.

The antenna 370 may be disposed between the rear plate 380 and the battery 350. The antenna 370 may include, for example, a near field communication "NFC" antenna, a wireless charging antenna, and/or a magnetic secure transmission "MST" antenna. The antenna 370 may, for example, communicate with an external device via near-field communication, or wirelessly transmit and receive power required for charging. An antenna structure may be formed by a part of the side bezel structure 310 and/or the first support member 311, or a combination thereof.

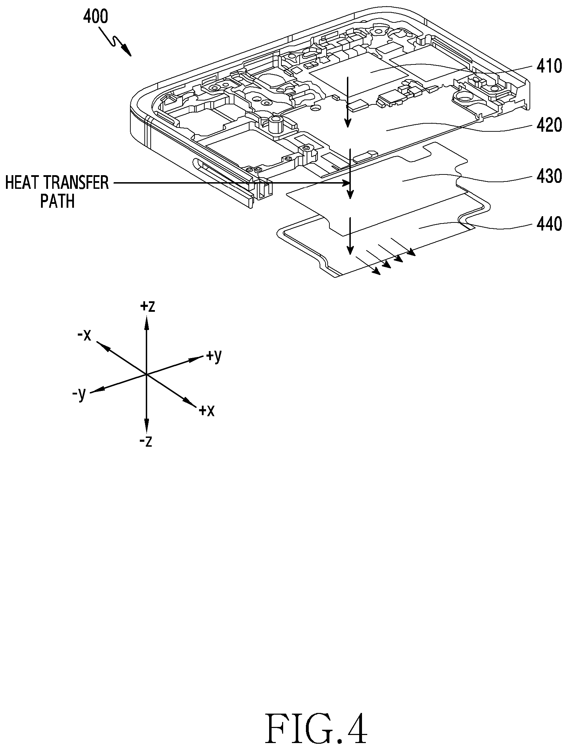

FIG. 4 is a view for illustrating a position and a heat transfer path of a conventional vapor chamber.

In FIG. 4, a first direction (a +z direction) corresponds to a direction facing the rear surface of the electronic device 400, and a second direction (a -z direction) corresponds to a direction facing the front surface (the display direction) of the electronic device 400.

Referring to FIG. 4, the electronic device 400 includes a processor 410, a support member 420 (corresponding generally to the first support member 311 of FIG. 3), a tape 430 and a vapor chamber 440.

The processor 410 is a primary heat source among the components of the electronic device 400, and may be an application processor. The processor 410 is disposed on the first directional side of the support member 420. Although not depicted, a TIM may be disposed between the processor 410 and the support member 420 to facilitate the heat transfer from the processor 410 to the vapor chamber 440. In addition, the processor 410 may be mounted on a main printed circuit board assembly (not shown) and protected together with the main printed circuit board assembly by a cover (not shown). The cover has a wider shape than the processor 410, and a plurality of holes may be formed in a peripheral region of the cover for securing fastening members (e.g., screws). In this case, the cover may be fastened to the support member 420 through the fastening members, covering the processor 410.

The vapor chamber 440 is arranged in the second direction based on the support member 420, and may occupy only a partial region of the support member 420. The vapor chamber 440 may extend in the +x direction and absorb some amount of heat generated by the display (not shown) and the battery (not shown) positioned in the second direction. The vapor chamber 440 is secured by the tape 430 disposed between the support member 420 and the vapor chamber 440. The tape 430 may be a double-sided tape to provide adhesive bonding to both the vapor chamber 440 and the support member 420.

In such devices, the vapor chamber 440 is disposed in the second direction based on the support member 420, rather than in the first direction. Furthermore, the vapor chamber 440 is disposed on the second direction side which is a relatively flat space, due to mounting difficulties in the first direction side including various components. The tape 430 is thus used to secure the vapor chamber 440 on the second direction side of the support member 420, but a damage may occur on removal of the vapor chamber 440 which has been fixed by the tape 430, such as on removal for recycling.

In addition, as shown in FIG. 4, the heat produced by the processor 410 is transferred in order of: the support member 420 -> the tape 430 -> the vapor chamber 440. This may lower the heat transfer efficiency, and residual heat may not actually be transferred as intended. Residual heat which is not transferred as intended may be transmitted to other components, result in overall durability issues for the electronic device 400.

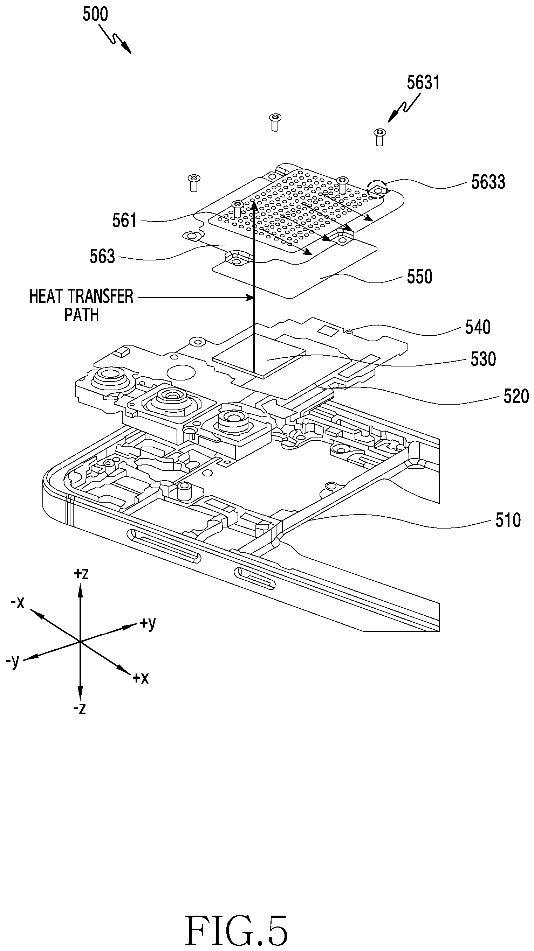

As mentioned above, considering that the primary heat source inside the electronic device is the processor , the inventors have realized it is possible to reduce the thickness of the electronic device and concurrently increase the heat transfer efficiency by modifying the structure, the shape, and the arrangement of the vapor chamber. Various embodiments for achieving related advantages are described with reference to FIG. 5 through FIG. 11.

FIG. 5 is an exploded perspective view of an electronic device including a vapor chamber according to an embodiment.

An electronic device 500 according to an embodiment includes the display 330 of FIG. 3, a support member 510, a processor 530, and a vapor chamber 560.

The electronic device 500 includes the display 330, the support member 510 being disposed behind the display 330. The support member 510 provides structural rigidity to the electronic device 500, and serves to support various electronic components.

The processor 530 is disposed in one region of the support member 510. According to an embodiment, the processor 530 may be an application processor. The processor 530 is a core component for performing computation and control of the electronic device 500, and produces heat during its operation. Hence, a heat dissipation structure is useful to efficiently manage the heat generated by the processor 530.

The electronic device 500 includes the vapor chamber 560. The vapor chamber 560 is a heat dissipation device for maximizing the heat transfer efficiency, contains a working fluid therein, and may effectively absorb, then disperse and transfer away heat using a phase change process.

The vapor chamber 560 includes a cooling unit 561 and a cover 563. The cover 563 has a hole 5633 formed through which a fastening member 5631 such as a screw may pass. The vapor chamber 560 may be fixed relative to the support member 510 by securing the fastening member 5631. The cover 563 has at least one hole 5633, and fastening members 5631 are provided corresponding to the number of holes 5633.

According to an embodiment, the vapor chamber 560 may be integrally formed with the cover 563 which covers the processor 530. The cover 563 protects the top surface of the processor 530, and simultaneously enhances thermal dissipation performance by being integrally formed with the vapor chamber 560. This integrated structure may more rapidly and efficiently dissipate the heat produced by the processor 530, and thus improve the thermal management performance of the electronic device 500. In addition, the electronic device 500 increases spatial efficiency (slimness) and improve the thermal management performance through the integrated structure of the vapor chamber 560 and the cover 563. This contributes to improving overall performance and reliability of the electronic device 500. Further, the vapor chamber 560 efficiently dissipates the heat from the processor 530, and increases overall durability of the electronic device 500.

As such, the electronic device 500 according to this embodiment is designed to effectively absorb and dissipate the heat generated by the processor 530, and may improve the performance and stability of the electronic device.

The cooling unit 561 according to an embodiment serves to absorb and dissipate the heat produced by the processor 530, and the cover 563 protects the cooling unit 561 and provides the structural stability to the vapor chamber 560.

The cover 563 includes the hole 5633 through which the fastening member 5631 such as a screw may pass. The hole 5633 facilitates insertion and engagement of the fastening member 5631 to secure the cover 563 to the support member 510. The fastening member 5631 connects the cover 563 and the support member 510 to stably fix the vapor chamber 560 relative to the support member 510.

The vapor chamber 560 is secured to the support member 510 through the engagement of the fastening member 5631. This ensures that the vapor chamber 560 maintains the contact with the processor 530, and prevents it from shaking or moving within the electronic device 500. The securing scheme using the fastening member 5631 simplifies installation and maintenance of the vapor chamber 560, and efficiently improves an assembly process of the electronic device 500. Unlike the illustration in FIG. 4, since the vapor chamber 560 is not secured by a double-sided tape in this embodiment, the vapor chamber 560 may be easily separated later.

In addition, the combination of the hole 5633 formed in the cover 563 and the fastening member 5631 allows to precisely adjustment the position of the vapor chamber 560. By tightly adjusting the fastening member 5631, the vapor chamber 560 and the processor 530 may contact each other more closely. Thus, the heat transfer efficiency between the processor 530 and the vapor chamber 560 may be maximized, and the thermal management performance of the electronic device 500 may be further improved.

A TIM 550 is disposed between the vapor chamber 560 and the processor 530, which serves to facilitate the effective transfer of the heat generated by the processor 530 to the vapor chamber 560. The TIM 550 is arranged to fill microscopic gaps between the surface of the processor 530 and the vapor chamber 560 to minimize heat transfer resistance, and thus rapidly dissipate the heat of the processor 530 to increase cooling efficiency.

Further, a printed circuit board 520 is interposed between the processor 530 and the support member 510, and serves to support the processor 530 and to provide electrical connection. The printed circuit board 520 allows signal transmission between the processor 530 and other electronic component in the system, and may also function to stably secure the processor 530 in the structure.

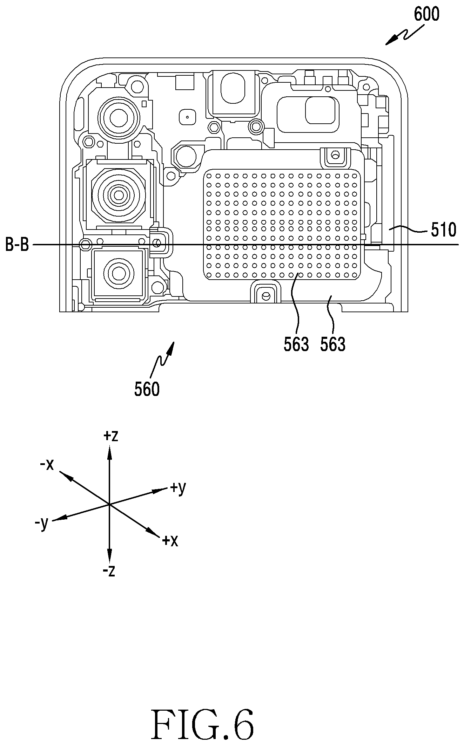

FIG. 6 is a rear view of an electronic device according to an embodiment.

Referring to FIG. 6, the vapor chamber 560 is stably seated on the support member 510. The vapor chamber 560 may be seated relative to the support member 510 in the display direction (the -x direction), and a bottom surface of the vapor chamber 560 may be secured while covering the TIM (not shown) and the processor (not shown).

The vapor chamber 560 may be mounted on the support member 510 by utilizing a fixing means such as a screw or a clamp, and this scheme may vary depending on the design.

The support member 510 may physically support the entire structure, and function to secure the processor 530 and related components including the printed circuit board 520.

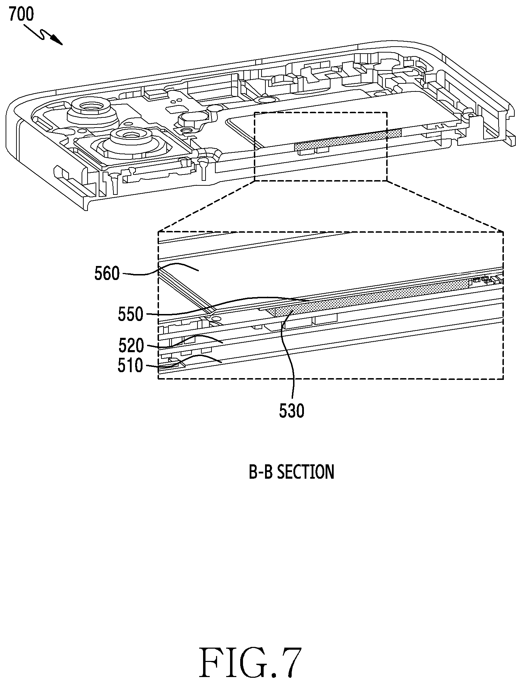

FIG. 7 is a cross-sectional perspective view of an electronic device when viewed from the back according to an embodiment.

An electronic device 700 according to an embodiment has a stacked structure including a vapor chamber 560, a TIM 550, a processor 530, a printed circuit board 520, and a support member 510 in sequence. However, it is noted that stacking may be performed in the reverse order of the above sequence to fabricate the illustrated stacked structure, and the stacking order may be changed depending on the manufacturing process. Such a stacked structure contributes to maximizing the cooling performance of the electronic device by effectively dissipating the heat generated by the processor 530.

The support member 510 according to an embodiment provides an internal frame of the electronic device 700, and serves to support other components including the display 330 of FIG. 3. This may be designed to provide overall mechanical strength of the electronic device 700, and to stably secure internal components.

The printed circuit board 520 is disposed above the support member 510, and various electronic components including the processor 530 are mounted on the printed circuit board 520. The printed circuit board 520 provides a core signal transmission path for the electronic device 700, and supports electrical connections between the processor 530 and other electronic components.

The processor 530 is mounted on the printed circuit board 520. Since the processor 530 produces significant heat during its operation, effective thermal management is crucial.

The TIM 550 is disposed on the processor 530. The TIM 550 reduces the heat transfer resistance between the processor 530 and the vapor chamber 560, and facilitates the rapid transfer of the heat generated by the processor 530 to the vapor chamber 560. The TIM 550 may typically include a high thermal conductivity material such as aluminum oxide Al₂O₃, aluminum nitride AlN, or silicon carbide SiC, and thus further enhance the cooling performance of the processor 530.

The vapor chamber 560 is disposed on the uppermost layer, which effectively disperses the heat transferred from the processor 530. The vapor chamber 560 is formed in a sealed structure containing a working fluid therein, and the heat transferred from the processor 530 rapidly diffuses as it vaporizes the working fluid. Next, the vapor moves within the chamber and disperses the heat, condenses back to fluid after cooling and circulates repeatedly. This heat transfer scheme maximizes the cooling performance of the electronic device, and enables long-term stable operation of the processor 530.

Thanks to this stacked structure, the electronic device 700 according to the disclosure may effectively manage the heat produced by the processor 530, and consequently optimizes the performance of the electronic device and ensures the stable operation even in the long-term use.

According to an embodiment, the printed circuit board 520 may be disposed between the support member 510 and the vapor chamber 560, and the processor 530 may be mounted on the printed circuit board 520. The printed circuit board 520 provides electrical connections between the processor 530 and other electronic components, thus enabling the signal transmission and the power supply. In addition, the printed circuit board 520 structurally supports the processor 530 and enhances the durability and the stability of the device.

According to an embodiment, the TIM 550 may be disposed between the processor 530 and the vapor chamber 560. The TIM 550 reduces the heat transfer resistance and allows more efficiently transfer of the heat generated by the processor 530 to the vapor chamber 560 by filling the microscopic gaps between the processor 530 and the vapor chamber 560. Thus, the cooling performance of the electronic device 500 may be improved, and thermal stability of the processor 530 may be obtained.

According to an embodiment, the cover 563 covering the processor 530 is integrally formed with the vapor chamber 560, and the hole 5633 may be formed on the outer periphery of the cover 563 into which at least one fastening member 5631 may be inserted. If the fastening member 5631 is inserted through the hole 5633, the vapor chamber 560 may be mounted more stably, and the contact with the processor 530 may be enhanced, thus maximizing the heat transfer efficiency.

According to an embodiment, at least one screw may be used as the fastening member 5631. The screw serves to firmly secure the vapor chamber 560 and the support member 510 or other component, and may enhance the structural stability of the electronic device 500 in the assembly process.

According to an embodiment, the vapor chamber 560 may be designed such that the TIM and the processor are forced into more close contact by rotation of the screw. As the screw is fastened, the vapor chamber 560 may be compressed toward the processor 530 to more uniformly spread the TIM, thus optimizing the heat transfer from the processor 530 to the vapor chamber 560.

According to an embodiment, the fastening member 5631 may be coupled with the support member 510 by passing through the hole 5633 formed in the cover 563. Hence, the vapor chamber 560 may be firmly secured to the support member 510, and the durability of the electronic device 500 is enhanced. In addition, such structural coupling may increase resistance against an external impact or vibration and enhance the reliability of the device.

According to an embodiment, a plurality of micro protrusions may be formed inside the vapor chamber 560 to improve the heat transfer performance. The micro protrusions optimize the vapor flow generating within the chamber, and enable faster heat diffusion by increasing an internal surface area. This structure may further improve the cooling performance of the vapor chamber.

According to an embodiment, the TIM 550 may include at least one of Al₂O₃, AlN or SiC. These materials have high thermal conductivity, and also serve to rapidly transfer the heat generated by the processor 530 to the vapor chamber 560. In addition, these materials have high durability and suffer low performance degradation even in the long-term use, and may contribute to improving the thermal management performance of the electronic device 500.

According to an embodiment, the heat generated by the processor 530 is transferred to the vapor chamber 560 through the TIM, and then efficiently dispersed within the vapor chamber. In doing so, the vapor chamber 560 may serve to rapidly diffuse the heat by circulating the vapor therein, and thus maintain a consistent temperature of the processor 530. As a result, applying the structure of the disclosure may effectively address the heating problem of the electronic device 500, and enable the stable operation without the performance degradation even in the long-term use.

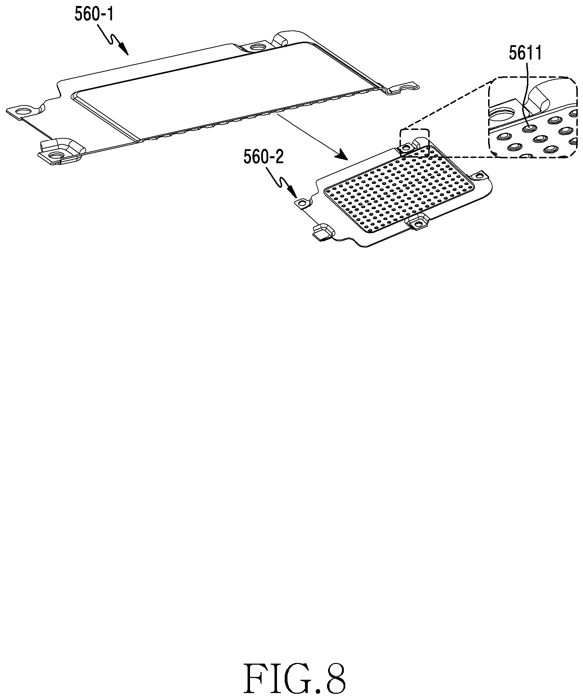

FIG. 8 is a configuration view of a vapor chamber 560 according to an embodiment.

The vapor chamber 560 is a heat dissipation device designed to enhance the thermal management performance of the electronic device, and has a sealed structure containing the working fluid therein. The vapor chamber 560 serves to efficiently absorb and dissipate the heat produced by the processor 530, and thus to stabilize the temperature of the processor 530.

The vapor chamber 560 includes an upper surface 560-1 and a lower surface 560-2, and the two surfaces may be designed considering the heat transfer and the structural strength.

The upper surface 560-1 of the vapor chamber 560 is a surface where the vapor generated inside the vapor chamber 560 condenses, and aids in the heat release to the outside. The upper surface 560-1 may also be structurally designed to be coupled with an additional heat dissipation fin or a heat sink. In addition, it may be fabricated with a highly thermally conductive material to interface with the external air and thus increase the thermal conductivity between the vapor chamber 560 and the external air to thereby more effectively dissipate heat thereto.

The lower surface 560-2 of the vapor chamber 560 is a surface directly contacting the processor 530 or the TIM 550, and serves to rapidly absorb the heat transferred from the processor 530. In this case, the TIM 550 may be disposed between the processor 530 and the vapor chamber 560 to maximize the heat transfer efficiency. The lower surface 560-2 may be formed of a metal material (e.g., copper or aluminum alloy) having high thermal conductivity, and may optimize the contact area with the processor 530 by having a smooth surface.

According to an embodiment, the vapor chamber 560 may include various structures therein to enhance the heat transfer performance, one of which may be micro protrusions 5611. According to an embodiment, the plurality of micro protrusions 5611 may be formed in the inner surface of the vapor chamber 560. The micro protrusions 5611 according to an embodiment serve to optimize the vapor flow while the working fluid inside the chamber is vaporized and condensed, and to increase the heat transfer area. The shape of the micro protrusions 5611 according to an embodiment may of various forms such as a conical shape, a hemispherical shape, or a nano-structured pattern, and such shapes may help uniformly disperse the internal vapor flow and optimize heat exchange performance.

According to an embodiment, the vapor chamber 560 may include a wick structure therein, which serves to induce capillary flow of the working fluid. The wick structure is typically formed of a porous metal material (e.g., a copper mesh or a sintered metal powder structure), and may maintain continuous cooling performance by inducing the condensed liquid back toward the lower surface 560-2 contacting the processor 530.

According to an embodiment, the working fluid for transferring the heat may be sealed within the vapor chamber 560. The working fluid may be a material such as water (H₂O), methanol, or acetone, which may vaporize at a low temperature, and serves to effectively transfer the heat by repeatedly vaporizing and condensing based on an internal pressure of the vapor chamber.

The structure of the vapor chamber 560 rapidly dissipates the heat generated by the processor 530, maximizes the cooling performance of the electronic device, and thus enables the long-term stable operation of the electronic device.

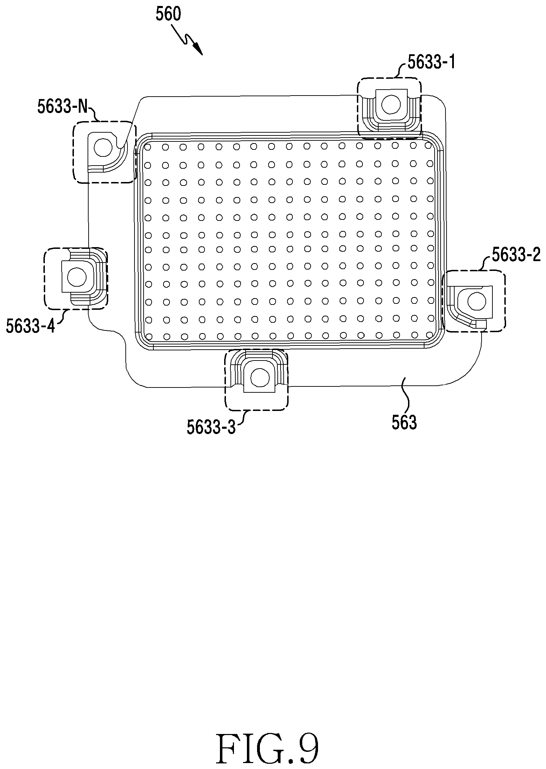

FIG. 9 is a configuration view of a cover of a vapor chamber according to an embodiment.

As mentioned earlier, the cover 563 may cover the upper surface 560-1 of the vapor chamber 560. The cover 563 protects the exterior of the vapor chamber 560, and supports the efficient thermal management by sealing the vapor generated therein. Additionally, a plurality of holes 5633-1, 5633-2, 5633-3, 5633-4, and 5633-N may serve to couple and secure the vapor chamber 560 to external components.

The cover 563 is a structure for covering the top of the vapor chamber 560, and serves to seal and protect the vapor and the working fluid inside the vapor chamber. Thus, it is possible to prevent leakage of the working fluid, and to maintain efficient vaporization and condensation within the vapor chamber.

The cover 563 may comprise, or be formed of a TIM, and be designed to dissipate the heat generated inside the vapor chamber to the outside. This contributes to enhancing the heat transfer performance within the vapor chamber. A heat dissipation fin or a structure for the heat release may be added to the outer surface of the cover 563.

The plurality of holes 5633-1, 5633-2, 5633-3, 5633-4, and 5633-N are formed along the periphery of the cover 563, and these holes may serve as fastening member insertion holes for coupling the vapor chamber 560 to the support member 510 or other components. Each hole is disposed at an appropriate interval, to help stably fix the vapor chamber 560.

If the fastening member (e.g., a screw) is inserted into the hole, the vapor chamber 560 and other components are mechanically coupled, and the vapor chamber 560 is stably mounted. Hence, the heat transfer between the vapor chamber 560 and the processor 530 is optimized, and the thermal management is achieved more efficiently. As the vapor chamber 560 is secured through the plurality of holes, the adhesion between the TIM 550 and the processor 530 is enhanced, and the heat transfer performance is maximized.

The plurality of holes 5633-1, 5633-2, 5633-3, 5633-4, and 5633-N support stable coupling between the vapor chamber 560 and other components, and enable the device to stably operate with the vapor chamber secured even under an external impact or vibration.

The plurality of holes 5633-1, 5633-2, 5633-3, 5633-4, and 5633-N contribute to optimizing the heat dissipation, and to efficiently lower the temperature inside the device together with the structure of the cover 563. This may help the heat release to the outside, and thereby keep the electronic device from overheating.

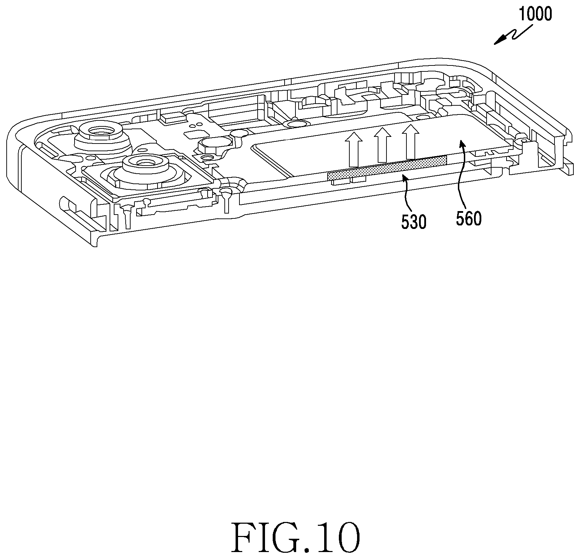

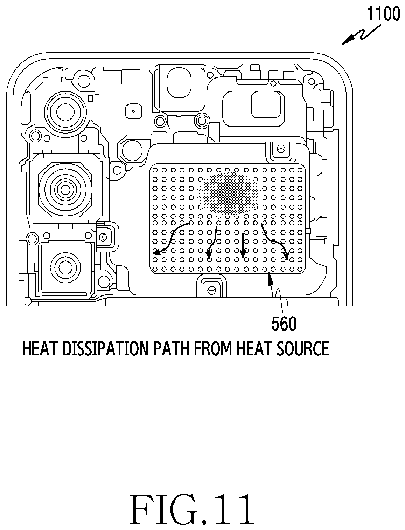

FIG. 10 illustrates a heat transfer path of an electronic device according to an embodiment, and FIG. 11 illustrates a heat dissipation path of a vapor chamber according to an embodiment.

Referring to FIG. 10, heat may be produced from the processor 530, transferred to the vapor chamber 560 through the TIM 550 (FIG. 5), absorbed by the vapor flow within the vapor chamber 560 and released to the outside.

Referring to FIG. 11, heat produced by the processor 530 may be transferred to the vapor chamber 560 through the TIM 550, and the heat absorbed inside the vapor chamber 560 may be released to the outside through the cover 563 (FIG. 5). The vapor chamber 560 is secured using the plurality of holes 5633-1, 5633-2, 5633-3, 5633-4, and 5633-N, and the heat may be efficiently transferred to stably maintain the temperature of the device.

Meanwhile, the stacked structure of the processor 530 described above may be also applied to the battery 350 of FIG. 3. In this case, the display 330 of FIG. 3, the battery 350 of FIG. 3, the substrate 340 of FIG. 3, the TIM, and the vapor chamber may be stacked in order in the electronic device. The battery 350 may be disposed substantially coplanar with the substrate 340, and the TIM may be omitted according to the embodiment.

As described above, the support member 510 is formed of a material selected to stably support major components such as the display 330, the substrate 340 and the battery 350 within the device, and may be fabricated with a metal or a high-strength plastic in general. The display 330 may be coupled to one surface of the support member 510.

The substrate 340 may be coupled to the other surface of the support member 510. The substrate 340 is a core component for accommodating and connecting the electronic components of the electronic device. The substrate typically includes a PCB, and may establish an electronic circuit including various electronic components mounted thereto. The substrate 340 may provide electrical connections allowing the battery 350 and other internal components to operate efficiently with each other.

The battery 350 is a device disposed on one surface of the substrate 340 to supply power to the electronic device. The battery typically includes a rechargeable cell such as a lithium-ion battery or a lithium polymer battery, and provides the energy for the entire operation of the electronic device. Since the battery 350 supplies constant voltage and current to the device, and may thus not be able to avoid heating, it is important to effectively manage the generated heat. Hence, the stacked structure applied to the processor 530 may be applied as it is to the battery 350.

The vapor chamber serves to absorb and disperse the heat produced by the battery 350. After absorbing the heat from the battery 350, the vapor chamber rapidly disperses the corresponding heat to other components within the electronic device. Thus, the battery may be prevented from overheating or being thermally damaged.

The cover of the vapor chamber may be integrally formed to cover the battery 350. The cover maximizes the heat transfer performance within the vapor chamber, and helps efficiently release the heat generated by the battery 350 to the outside through the vapor chamber. Additionally, the cover provides the mechanical protection, and functions to protect the vapor chamber and its internal components from an external environment. The cover seals the perimeter of the vapor chamber, and optimizes the heat conduction path formed therein.

The electronic device 500 of FIG. 5 according to an embodiment may include a display 330 of FIG. 3, a support member 510 of FIG. 5 disposed on a rear surface of the display 330, a processor 530 disposed in one region of the support member 510 of FIG. 5 and a vapor chamber 560 for absorbing heat produced by the processor 530. The vapor chamber 560 according to an embodiment may be integrally formed with a cover 563 which covers the processor.

The electronic device 500 according to an embodiment may further include a printed circuit board 520 disposed between the support member 510 and the vapor chamber 560. The processor 530 according to an embodiment may be mounted on the printed circuit board 520.

The electronic device 500 according to an embodiment may further include a thermal interface material 550 disposed between the processor 530 and the vapor chamber 560 and transferring the heat produced by the processor 530 to the vapor chamber 560.

The cover 563 according to an embodiment may have at least one hole formed at a periphery surrounding the vapor chamber 560, into which at least one fastening member is inserted.

The at least one fastening member 5631 according to an embodiment may include at least one screw.

The vapor chamber 560 according to an embodiment may cause the thermal interface material 550 and the processor 530 to be more closely contacted, by rotational force of the at least one screw 5634.

The at least one fastening member according to an embodiment may be coupled with the support member 510 by passing through the at least one hole 5633 to secure the vapor chamber 560 to the support member 510.

The vapor chamber 560 according to an embodiment may have plurality of micro protrusions 5611 formed therein to improve heat transfer.

The thermal interval material 550 according to an embodiment may include at least one of Al₂O₃, AlN or silicon carbide SiC.

According to an embodiment, the heat produced by the processor 530 may be transferred to the vapor chamber 560 via the thermal interface material 550, and dispersed in the vapor chamber 560.

An electronic device according to an embodiment may include a support member 510, a display 330 coupled to one surface of the support member 510, a substrate 340 coupled to the other surface of the support member 510, a battery 350 disposed on one surface of the substrate 340 and a vapor chamber 560 for absorbing heat produced by the battery 350. The vapor chamber 560 according to an embodiment may be integrally formed with a cover 563 which covers the battery 350.

According to an embodiment, at least a part of the battery 350 may be disposed substantially coplanar with the substrate 340.

The electronic device according to an embodiment may further include a thermal interface material 550 disposed between the battery 350 and the vapor chamber 560 and transferring the heat produced by the battery 350 to the vapor chamber 560.

The cover 563 according to an embodiment may have at least one hole formed at a periphery surrounding the vapor chamber 560, into which at least one fastening member 5631 is inserted.

The at least one fastening member 5631 according to an embodiment may include at least one screw.

The vapor chamber 560 according to an embodiment may cause the thermal interface material 550 and the battery 350 to be more closely contacted, by rotational force of the at least one screw.

The at least one fastening member 5631 according to an embodiment may be coupled with the substrate by passing through the at least one hole 5633 to secure the vapor chamber 560 to the substrate 340.

The vapor chamber 560 according to an embodiment may have plurality of micro protrusions 5611 formed therein to improve heat transfer.

The thermal interval material 550 according to an embodiment may include at least one of Al₂O₃, AlN or SiC.

According to an embodiment, the heat produced by the battery 350 may be transferred to the vapor chamber 560 via the thermal interface material 550, and dispersed in the vapor chamber 560.

The electronic device according to various embodiments of the disclosure may be a device of various types. The electronic device may include, for example, a portable communication device (e.g., a smartphone), a computer device, a portable multimedia device, a portable medical device, a camera, a wearable device, or a home appliance. The electronic device according to an embodiment of the disclosure is not limited to the devices described above.

It should be appreciated that various embodiments of the disclosure and the terms used therein are not intended to limit technological features disclosed in this document to particular embodiments, and embrace various modifications, equivalents, or alternatives of a corresponding embodiment. With respect to the descriptions of the drawings, similar reference numerals may be used for similar or related elements. A singular form of a noun corresponding to an item may include one or more of the items, unless the relevant context clearly indicates otherwise. As used herein, each of such phrases as "A or B", "at least one of A and B", "at least one of A or B", "A, B, or C", "at least one of A, B, and C", and "at least one of A, B, or C", may include one, or all possible combinations of the items enumerated together in a corresponding one of the phrases. Such terms as "1st" and "2nd", or "first" and "second" may be used to simply distinguish a corresponding component from another, and do not limit the corresponding components in other aspect (e.g., importance or order). If an element (e.g., a first element) is referred to, with or without the term "operatively" or "communicatively", as "coupled" or "connected" to another element (e.g., a second element), it means that the element may be coupled with the other element directly (e.g., via a wired connection), wirelessly, or via a third element.

The term "module" used in various embodiments of the disclosure may include a unit implemented in hardware, software or firmware, and may be interchangeably used with a term, for example, logic, a logic block, a part, or circuitry. The module may be a single integral component, or a minimum unit or part thereof, for performing one or more functions. For example, according to an embodiment, the module may be implemented in a form of an application-specific integrated circuit "ASIC".

Various embodiments of the disclosure may be implemented as software (e.g., the program 140) including one or more instructions which are stored in a storage medium (e.g., the internal memory 136 or the external memory 138) readable by a machine (e.g., the electronic device 101). For example, a processor (e.g., the processor 120) of the machine (e.g., the electronic device 101) may invoke at least one of the one or more instructions stored in the storage medium, and execute it or them. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Herein, 'non-transitory' simply means that the storage medium is a tangible device, and does not include a signal (e.g., an electromagnetic wave), but this term does not differentiate between a case where data is semi-permanently stored in the storage medium and a case where the data is temporarily stored.

According to an embodiment, a method according to various embodiments of the disclosure may be included and provided in a computer program product. The computer program product may be traded as a product between a seller and a buyer. The computer program product may be distributed in the form of a machine-readable storage medium (e.g., a compact disc read only memory "CD-ROM"), or may be distributed (e.g., downloaded or uploaded) directly or online via an application store (e.g., Play Store^{TM}) or between two user devices (e.g., smart phones). In the online distribution, at least a part of the computer program product may be temporarily stored in the machine-readable storage medium such as a memory of a manufacturer's server, an application store server, or a relay server, or may be temporarily generated.

According to various embodiments, each component (e.g., a module or a program) of the above-described components may include a single entity or multiple entities. According to various embodiments, one or more components or operations of the above-described components may be omitted, or one or more other components or operations may be added. Alternatively or additionally, a plurality of components (e.g., modules or programs) may be integrated as a single component. In this case, the integrated component may perform one or more functions of each component of the plurality of the components in the same or similar manner as they are performed by a corresponding component of the plurality of the components before the integration. According to various embodiments, operations performed by the module, the program or other component may be carried out sequentially, in parallel, repeatedly, or heuristically, one or more of the operations may be executed in a different order or omitted, or one or more other operations may be added.

The technical problems to be achieved by the disclosure are not limited to the technical problems mentioned above, and other technical problems not mentioned may be clearly understood by those skilled in the art of the technical field which the disclosure belongs to.

Effects obtainable from the disclosure are not limited to the above-mentioned effects, and other effects which are not mentioned may be clearly understood by those skilled in the art of the disclosure through the following descriptions.

## Claims

1. An electronic device comprising:
a display;
a support member disposed on a rear surface of the display;
a processor disposed in one region of the support member; and
a vapor chamber for absorbing heat produced by the processor,
wherein the vapor chamber is integrally formed with a cover which covers the processor.

2. The electronic device of claim 1, further comprising:
a printed circuit board disposed between the support member and the vapor chamber, wherein the processor is mounted on the printed circuit board.

3. The electronic device of claim 1 or 2, further comprising:
a thermal interface material disposed between the processor and the vapor chamber, for transferring heat produced by the processor to the vapor chamber.

4. The electronic device of any preceding claim, wherein the cover has at least one hole formed in a periphery thereof, the periphery of the cover surrounding the vapor chamber, the hole arranged to receive at least one fastening member inserted therein.

5. The electronic device of claim 4, wherein the at least one fastening member is coupled with the support member by passing through the at least one hole to secure the vapor chamber to the support member.

6. The electronic device of claim 4 or 5, wherein the at least one fastening member comprises a screw.

7. The electronic device of claim 3, or any one of claims 4 through 6 as dependent on claim 3, wherein the screw is arranged such that rotation thereof forces the thermal interface material into closer contact with the vapor chamber and with the processor.

8. The electronic device of any preceding claim, wherein the vapor chamber has plurality of micro protrusions formed therein.

9. The electronic device of claim 3, or any one of claims 4 through 8 as dependent on claim 3, wherein the thermal interval material comprises at least one of aluminum oxide Al₂O₃, aluminum nitride AlN, or silicon carbide SiC.

10. The electronic device of claim 3, or any one of claims 4 through 9 as dependent on claim 3, wherein heat produced by the processor is transferred to the vapor chamber via the thermal interface material and dispersed in the vapor chamber.

11. An electronic device comprising:
a support member;
a display coupled to one surface of the support member;
a substrate coupled to the other surface of the support member;
a battery disposed on one surface of the substrate; and
a vapor chamber for absorbing heat produced by the battery,
wherein the vapor chamber is integrally formed with a cover which covers the battery.

12. The electronic device of claim 11, wherein at least a part of the battery is disposed substantially coplanar with the substrate.

13. The electronic device of claim 11 or 12, further comprising:
a thermal interface material disposed between the battery and the vapor chamber, for transferring heat produced by the battery to the vapor chamber.

14. The electronic device of claim 13, wherein the cover has at least one hole formed in a periphery thereof, the periphery of the cover surrounding the vapor chamber, the hole arranged to receive at least one fastening member therein.

15. The electronic device of claim 14, wherein the at least one fastening member is coupled with the substrate by passing through the at least one hole to secure the vapor chamber to the substrate.
